(19) Europäisches Patentamt
European Patent Office
Office européen des brevets

(11) **EP 4 057 305 A1**

(12) **EUROPEAN PATENT APPLICATION**

(43) Date of publication:
**14.09.2022 Bulletin 2022/37**

(21) Application number: **22158208.3**

(22) Date of filing: **23.02.2022**

(51) International Patent Classification (IPC):
**H01F 27/28** (2006.01)　　**H01F 27/40** (2006.01)
**H01F 38/14** (2006.01)　　**H05K 1/02** (2006.01)

(52) Cooperative Patent Classification (CPC):
**H01F 27/2804; H01F 27/40; H01F 38/14;**
**H05K 1/0278;** H01F 2027/2809

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **09.03.2021　JP 2021037705**

(71) Applicant: **Nitto Denko Corporation**
**Ibaraki-shi, Osaka 567-8680 (JP)**

(72) Inventors:
• **TSUDA, Hisashi**
**Osaka, 567-8680 (JP)**
• **ICHIKAWA, Kazushi**
**Osaka, 567-8680 (JP)**
• **SASAKI, Takashi**
**Osaka, 567-8680 (JP)**
• **SUZUKI, Masafumi**
**Osaka, 567-8680 (JP)**

(74) Representative: **Müller-Boré & Partner**
**Patentanwälte PartG mbB**
**Friedenheimer Brücke 21**
**80639 München (DE)**

(54) **WIRELESS POWER SUPPLY WIRING CIRCUIT BOARD AND BATTERY MODULE**

(57)　Bendability of a wireless power supply wiring circuit board is improved. A wireless power supply wiring circuit board 1 includes an insulating layer 1012, a first wiring portion 1011 which is provided on one surface side in the thickness direction of the insulating layer 1012, a first region 101 including a second wiring portion 1013 which is provided on the other side in the thickness direction of the insulating layer 1012, a second region 102 in which the first wiring portion 1011 and the second wiring portion 1013 are provided on the same flat plane, a transceiver circuit portion 103, and a component mounting circuit portion 104 which is electrically connected to the transceiver circuit portion 103.

FIG.1A

**Description**

BACKGROUND OF THE INVENTION

The present invention relates to a foldable wireless power supply wiring circuit board and a battery module.

In order to meet the recent demand of downsizing and reduction in weight of electronic apparatuses, a flexible printed board on which electronic circuits are mounted may be bended and incorporated into an apparatus. For example, Patent Literature 1 (Japanese Unexamined Patent Publication No. 2018-174123) discloses that a double-sided flexible wiring circuit board is arranged to extend along a side wall surface of a secondary battery by utilizing the flexibility of the circuit board, and the circuit board is maintained to be bended at potions corresponding to a cathode terminal on one surface and an anode terminal on the other side, respectively.

SUMMARY OF THE INVENTION

However, because the flexible wiring circuit board itself must be downsized to achieve further downsizing of the electronic apparatus, points where force is applied to bend the circuit board at the predetermined portions are disadvantageously close to the predetermined portions. As a result, the bendability is deteriorated as large pressing force is required to perform the bending.

An object of the present invention is to provide a wireless power supply wiring circuit board and a battery module that have improved bendability.

According to a first aspect of the invention, a wireless power supply wiring circuit board includes: a first region which includes an insulating layer, a first wiring portion provided on one surface side in a thickness direction of the insulating layer, and a second wiring portion provided on the other side in the thickness direction of the insulating layer;

a second region in which the first wiring portion and the second wiring portion are provided on a same flat plane;
a transceiver circuit portion; and a component mounting circuit portion which is electrically connected to the transceiver circuit portion.

According to the arrangement above, the first region and the second region have the first wiring portion and the second wiring portion. On this account, electric connection between the first region and the second region is maintained. Furthermore, because the first wiring portion and the second wiring portion of the second region are provided on the same flat plane, the thickness of this region is small (i.e., the rigidity is low) as compared to the first region where the first wiring portion and the second wiring portion are stacked in the thickness direction, and hence the bendability is high at the second region as compared to a case where the entirety of the board is the first region.

The wireless power supply wiring circuit board of the first aspect of the invention is arranged so that the second region is a bending portion.

According to this arrangement, because the second region which is lower in rigidity than the first regions is set as the bending portion, the wireless power supply wiring circuit board is easily bendable.

The wireless power supply wiring circuit board of the first aspect of the invention is arranged so that, in the first region in vicinity of the bending portion, the first wiring portion is provided on a same flat plane as the second wiring portion on account of a via hole.

According to this arrangement, because the first wiring portion and the second wiring portion are separated from each other on the same flat plane in the bending portion, it is possible to supply different signals and currents to the first wiring portion and the second wiring portion, respectively.

The wireless power supply wiring circuit board of the first aspect of the invention is arranged so that, in the first region in vicinity of the bending portion, the first wiring portion is electrically connected to the second wiring portion by a via hole.

According to this arrangement, because the first wiring portion and the second wiring portion are connected to each other on the same flat plane in the bending portion, it is possible to supply same signals and currents to the first wiring portion and the second wiring portion, respectively.

The wireless power supply wiring circuit board of the first aspect of the invention is arranged so that the second region is arranged to fall within a range of 0.2 mm to 2 mm in width, and the wireless power supply wiring circuit board falls within a range of 30 $\mu$m to 100 $\mu$m in thickness.

The wireless power supply wiring circuit board of the first aspect of the invention further includes a supporting layer that is made of metal and is provided at least at a part of the first region.

According to this arrangement, because the rigidity of the first region is improved by the metal supporting layer, the rigidity of the entire board is improved.

The wireless power supply wiring circuit board of the first aspect of the invention is arranged so that the supporting layer falls within a range of 1 $\mu$m to 100 $\mu$m in thickness.

According to a second aspect of the invention, a wireless power supply wiring circuit board includes: a coil portion which is configured to convert an electromagnetic wave to AC power;

a first wiring portion which is connected to the coil portion and includes two conductive layers receiving the AC power are stacked; and
a first bending portion which is formed to traverse the first wiring portion and arranges the inner side of bend of the first wiring portion to be recessed, and the first bending portion including a first bending conductive layer in which a conductive layer formed on the inner side of the bend of the first wiring portion is integrated with a conductive layer formed on the outer side of the bend of the first wiring portion.

According to this arrangement, the first bending portion improves the bendability, while a state in which the two conductive layers are electrically connected across the entirety from one side to the other side of the first wiring portion is maintained.

According to the second aspect of the invention, the wireless power supply wiring circuit board includes: a second wiring portion in which two conductive layers receiving DC power of a secondary battery are stacked; and

a second bending portion which is formed to traverse the second wiring portion and arranges the inner side of bend of the second wiring portion to be recessed, and

the second bending portion including a second bending conductive layer in which a conductive layer formed on the inner side of the bend of the wiring portion is integrated with a conductive layer formed on the outer side of the bend of the wiring portion.

According to this arrangement, the second bending portion improves the bendability, while a state in which the two conductive layers are electrically connected across the entirety from one side to the other side of the second wiring portion is maintained.

The wireless power supply wiring circuit board of the second aspect of the invention is arranged so that

thickness Rb of the first bending portion and the second bending portion,
a curvature radius Ra of a neutral plane at the first bending portion and the second bending portion, and
distance L of the neutral plane satisfy
a relationship of $L=2\pi(Ra+Rb/2)/4$.

This arrangement makes it easy to design the first bending portion.

The wireless power supply wiring circuit board of the second aspect of the invention is arranged so that

thickness Ha of the first wiring portion and the second wiring portion,
thickness Rb of the first bending portion and the second bending portion, and
distance L of a neutral plane at the first bending portion and the second bending portion satisfy
a relationship of $Ha=0.85Rb+0.6L/\pi$.

This arrangement makes it easy to design the first bending portion.

The wireless power supply wiring circuit board of the second aspect of the invention is arranged so that

distance L of the first bending portion and the second bending portion falls within a range of 0.2 mm to 2 mm, and
thickness Ha of the first wiring portion and the second wiring portion falls within a range of 30 $\mu$m to 100 $\mu$m.

According to the second aspect of the invention, the first wiring portion and the second wiring portion have a supporting layer made of metal. This arrangement makes it possible to improve the rigidity of the wireless power supply wiring circuit board.

According to the second aspect of the invention, the supporting layer falls within a range of 1 $\mu$m to 100 $\mu$m in thickness.

In a battery module including the wireless power supply wiring circuit board and the secondary battery of the present invention, the distance between the second bending portion and the secondary battery falls within a range of 0.01 mm to 1.0 mm.

The present invention makes it possible to improve the bendability of the wireless power supply wiring circuit board.

BRIEF DESCRIPTION OF THE DRAWINGS

FIG. 1A illustrates the structure of a wireless power supply wiring circuit board in the thickness direction.
FIG. 1B illustrates the relationship between a first region and a second region of the wireless power supply wiring circuit board.
FIG. 1C illustrates the relationship between the first region and the second region of the wireless power supply wiring circuit board.
FIG. 1D illustrates the relationship between the first region and the second region of the wireless power supply wiring circuit board.
FIG. 2A illustrates the structure of the wireless power supply wiring circuit board in the width direction.
FIG. 2B illustrates the structure of the wireless power supply wiring circuit board in the width direction.
FIG. 2C illustrates the structure of the wireless power supply wiring circuit board in the width direction.
FIG. 3 illustrates a connection state between the first region and the second region.
FIG. 4A illustrates an important part of the wireless power supply wiring circuit board.
FIG. 4B is a cross section taken along a line X-X in FIG. 4A.
FIG. 5 illustrates a connection state between the first region and the second region.
FIG. 6A is a cross section of a first bending portion of the wireless power supply wiring circuit board, which is taken along an X-X line in FIG. 6B.

FIG. 6B is a plan view showing the first bending portion of the wireless power supply wiring circuit board.

FIG. 7A is a cross section of a second bending portion of the wireless power supply wiring circuit board, which is taken along an X-X line in FIG. 7B.

FIG. 7B is a plan view showing the second bending portion of the wireless power supply wiring circuit board.

FIG. 8 illustrates a case where the wireless power supply wiring circuit board is bended.

FIG. 9A illustrates a manufacturing process of the wireless power supply wiring circuit board.

FIG. 9B illustrates the manufacturing process of the wireless power supply wiring circuit board.

FIG. 9C illustrates the manufacturing process of the wireless power supply wiring circuit board.

FIG. 9D illustrates the manufacturing process of the wireless power supply wiring circuit board.

FIG. 9E illustrates the manufacturing process of the wireless power supply wiring circuit board.

FIG. 9F illustrates the manufacturing process of the wireless power supply wiring circuit board.

FIG. 9G illustrates the manufacturing process of the wireless power supply wiring circuit board.

FIG. 9H illustrates the manufacturing process of the wireless power supply wiring circuit board.

FIG. 9I illustrates the manufacturing process of the wireless power supply wiring circuit board.

FIG. 9J illustrates the manufacturing process of the wireless power supply wiring circuit board.

FIG. 9K illustrates the manufacturing process of the wireless power supply wiring circuit board.

FIG. 10 is a perspective view of a battery module.

FIG. 11A is a cross section of a first bending portion of the wireless power supply wiring circuit board, which is taken along an X-X line in FIG. 11B.

FIG. 11B is a plan view showing the first bending portion of the wireless power supply wiring circuit board.

DESCRIPTION OF THE PREFERRED EMBODIMENTS

(Wireless Power Supply Wiring Circuit Board of First Embodiment)

The following will describe First Embodiment of the present invention with reference to drawings.

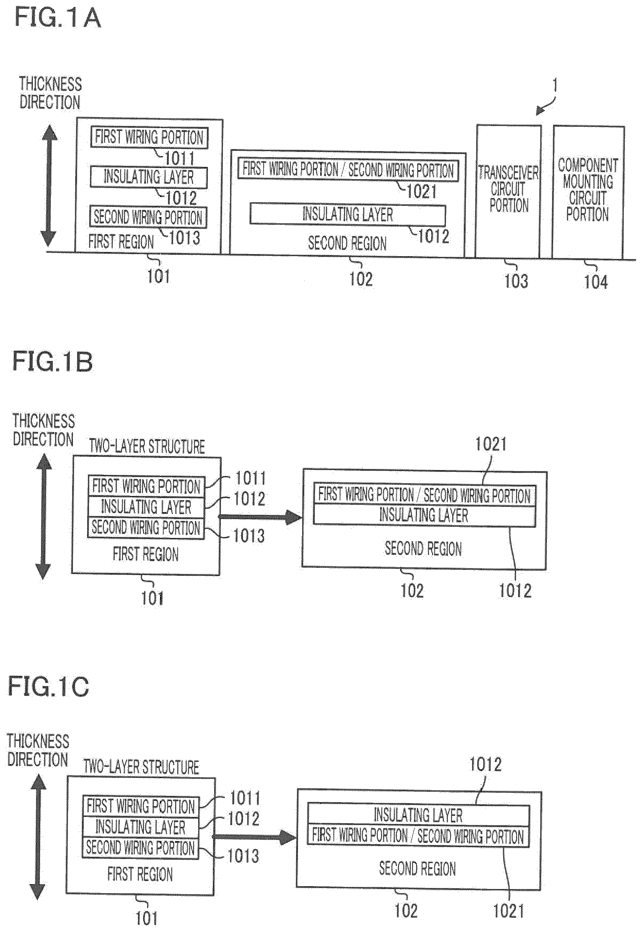

As shown in FIG. 1A, a wireless power supply wiring circuit board 1 includes an insulating layer 1012, a first wiring portion 1011 which is provided on one surface side in the thickness direction of the insulating layer 1012, a first region 101 including a second wiring portion 1013 which is provided on the other side in the thickness direction of the insulating layer 1012, a second region 102 in which the first wiring portion 1011 and the second wiring portion 1013 are provided on the same flat plane, a transceiver circuit portion 103, and a component mounting circuit portion 104 which is electrically connected to the transceiver circuit portion 103.

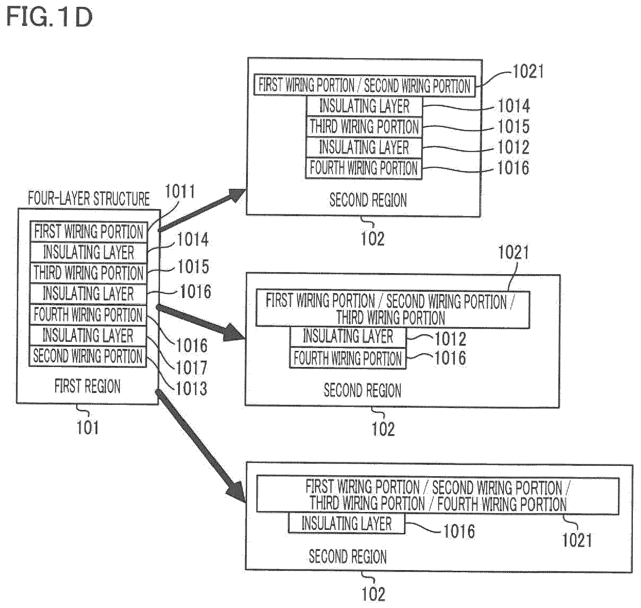

In this regard, as shown in FIG. 1B and FIG. 1C, the expression "provided on one surface side in the thickness direction" in the first region 101 may indicate a layer structure in which the first wiring portion 1011 is joined with one surface in the thickness direction of the insulating layer 1012 or a layer structure in which the first wiring portion 1011 is provided at a location separated from one surface in the thickness direction of the insulating layer 1012. The layer structure in which the first wiring portion 1011 is provided at a location separated from the insulating layer 1012 is, for example, as shown in FIG. 1D, a structure in which a third wiring portion 1015 and an insulating layer 1014 are provided between the first wiring portion 1011 and the insulating layer 1012. Meanwhile, as shown in FIG. 1B and FIG. 1C, the expression "provided on the other surface in the thickness direction" in the first wiring portion 1011 may indicate a layer structure in which the second wiring portion 1013 is joined with the other surface in the thickness direction of the insulating layer 1012 or a layer structure in which the second wiring portion 1013 is provided at a location separated from the other surface in the thickness direction of the insulating layer 1012. The layer structure in which the second wiring portion 1013 is provided at a location separated from the insulating layer 1012 is, for example, as shown in FIG. 1D, a structure in which a fourth wiring portion 1016 and an insulating layer 1017 are provided between the second wiring portion 1013 and the insulating layer 1012.

As such, the first region 101 has a multilayer substrate having two or more layers of wiring portions (conductive layers) including the first wiring portion 1011 and the second wiring portion 1013. While FIG. 1D shows a multilayer substrate having four layers of wiring portions (conductive layers) 1011, 1015, 1016, and 1013, the disclosure is not limited to this arrangement. The multilayer substrate may have two or three layers or may have five or more layers. In addition to the above, while FIG. 1D shows a multilayer substrate in which the first wiring portion 1011 and the second wiring portion 1013 are the uppermost layer and the lower most layer in the direction in which the layers are stacked, the disclosure is not limited to this arrangement. Any one of wiring portions (conductive layers) in the multilayer substrate may be set as the first wiring portion 1011, and one of the remaining wiring portions (conductive layers) may be set as the second wiring portion 1013.

The expression "provided on the same flat plane" in the second region 102 indicates that the first wiring portion 1011 and the second wiring portion 1013 exist on a flat plane orthogonal to the thickness direction of the insulating layer 1012. In other words, the expression indicates that an integrated wiring portion 1021 including the first wiring portion 1011 and the second wiring portion 1013 exists on a flat plane orthogonal to the thickness direction of the insulating layer 1012. As shown in FIG. 1B and FIG. 1C, the integrated wiring portion 1021 may be provided on either one surface side or the other surface side in the thickness direction of the insulating layer 1012. The integrated wiring portion 1021 is preferably provided at the center in the thickness direction of the second region 102. This is because, when the integrated wiring portion 1021 is at a neutral plane while the second region 102 is set as a bending portion 130, force required for bending is reduced because, even if tensile force or compression force is generated at the outer side or the inner side of the bend, the first wiring portion 1011 and the second wiring portion 1013 that are higher in rigidity at the integrated wiring portion 1021 than resin are not influenced by the tensile force or the compression force. In other words, the second region 102 is easily bendable even if the first region 101 and the second region 102 are identical in thickness.

In a multilayer structure including three or more layers of wiring portions, the integrated wiring portion 1021 including the first wiring portion 1011 and the second wiring portion 1013 may include another wiring portion in addition to the first wiring portion 1011 and the second wiring portion 1013. For example, as shown in FIG. 1D, the second region 102 may be provided with the integrated wiring portion 1021 including the first wiring portion 1011, the second wiring portion 1013, and the third wiring portion 1015. Furthermore, the second region 102 may be provided with the integrated wiring portion 1021 including the first wiring portion 1011, the second wiring portion 1013, the third wiring portion 1015, and the fourth wiring portion 1016. In other words, the second region 102 is arranged to have a smaller number of layers than the first region 101, as two or more wiring portions, which are selected from the wiring portions of the first region 101 in which wiring portions (conductive layers) are stacked, are provided on the same plane.

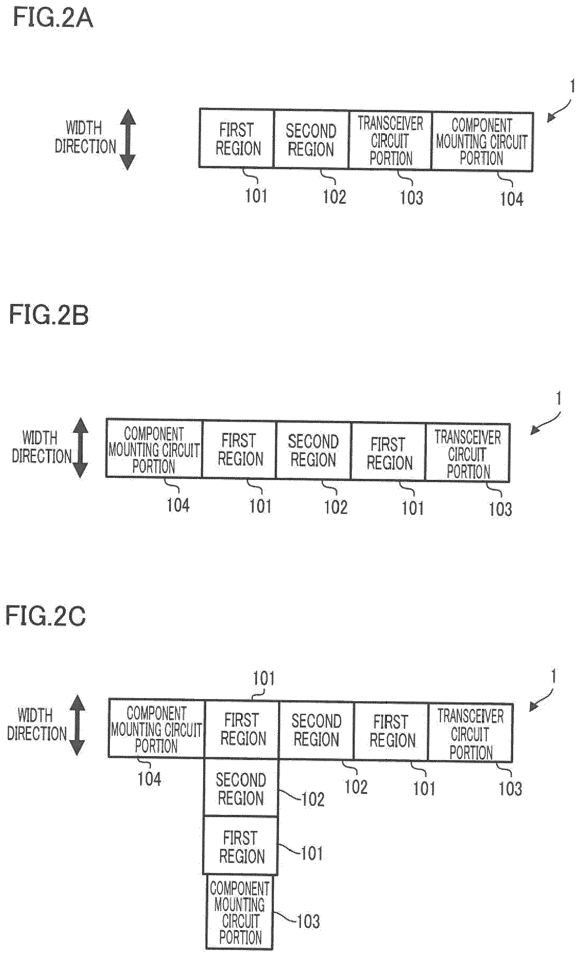

The number of each of the first regions 101 and the second region 102 arranged as described above is one or more in the wireless power supply wiring circuit board 1. For example, as shown in FIG. 2A, in a plan view of the wireless power supply wiring circuit board 1, the first region 101, the second region 102, the transceiver circuit portion 103, and the component mounting circuit portion 104 may be provided in series in this order. Alternatively, for example, as shown in FIG. 2B, in a plan view of the wireless power supply wiring circuit board 1, the component mounting circuit portion 104, the first region 101, the second region 102, the first region 101, and the component mounting circuit portion 104 may be provided in series in this order. In other words, in the wireless power supply wiring circuit board 1, the first regions 101 and the second regions 102 may be provided in an alternate manner. Furthermore, for example, as shown in FIG. 2C, in a plan view of the wireless power supply wiring circuit board 1, the first region 101 and the second region 102 are provided in the width direction.

The transceiver circuit portion 103 is, for example, a coil portion configured to convert an electromagnetic wave to electric power. The component mounting circuit portion 104 is, for example, a connection part at which connection to a secondary battery is made. The transceiver circuit portion 103 and the component mounting circuit portion 104 may be electrically connected to each other directly, or may be indirectly connected to each other through the first region 101 and/or the second region 102.

The wireless power supply wiring circuit board 1 structured as described above is arranged so that the first region 101 and the second region 102 have the first wiring portion 1011 and the second wiring portion 1013. On this account, electric connection between the first region 101 and the second region 102 is maintained. Furthermore, because the first wiring portion 1011 and the second wiring portion 1013 of the second region 102 are provided on the same flat plane, the thickness of this region is small (i.e., the rigidity is low) as compared to the first region 101 where the first wiring portion 1011 and the second wiring portion 1013 are stacked in the thickness direction, and hence the bendability is high at the second region 102 as compared to a case where the entirety of the wireless power supply wiring circuit board 1 is the first region 101.

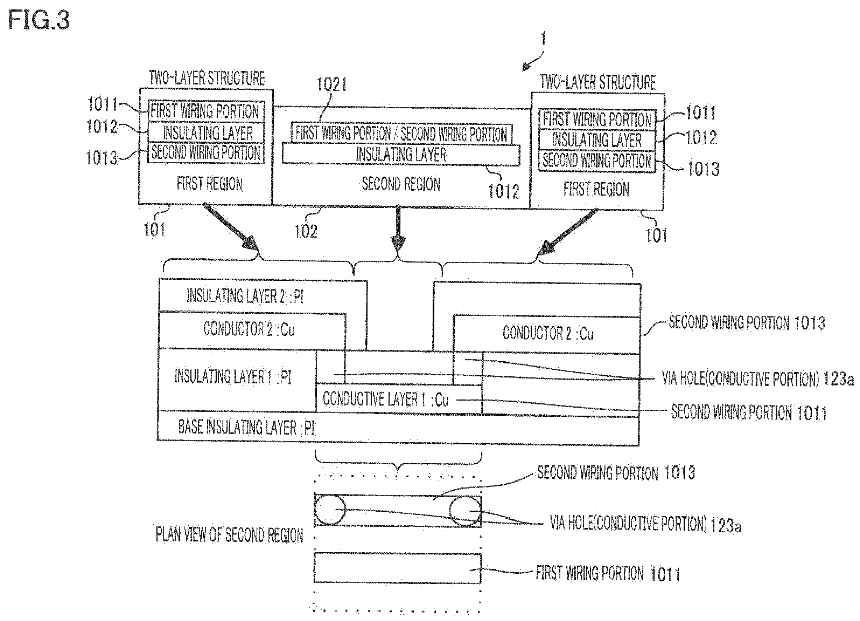

As shown in FIG. 3, the second region 102 of the wireless power supply wiring circuit board 1 may be a bending portion 130. The bending portion 130 is a portion where the wireless power supply wiring circuit board 1 that is a flat plate is bended so that the angle of the board region on one side of the bending portion 130 is different from the angle of the board region on the other side of the bending portion 130. When the second region 102 which is lower in rigidity than the first regions 101 is set as the bending portion 130, the wireless power supply wiring circuit board 1 is easily bendable.

As shown in FIG. 3, the wireless power supply wiring circuit board 1 may be arranged such that, in the first region 101 in the vicinity of the bending portion 130, the first wiring portion 1011 is provided on the same flat plane as the second wiring portion 1013 on account of a via hole that is a conductive portion 123a. The via hole is provided to achieve electrical conduction between layers of the board. Because in this case the first wiring portion 1011 and the second wiring portion 1013 are separated from each other on the same flat plane in the bending portion 130, it is possible to supply different signals and currents to the first wiring portion 1011 and the second wiring portion 1013, respectively.

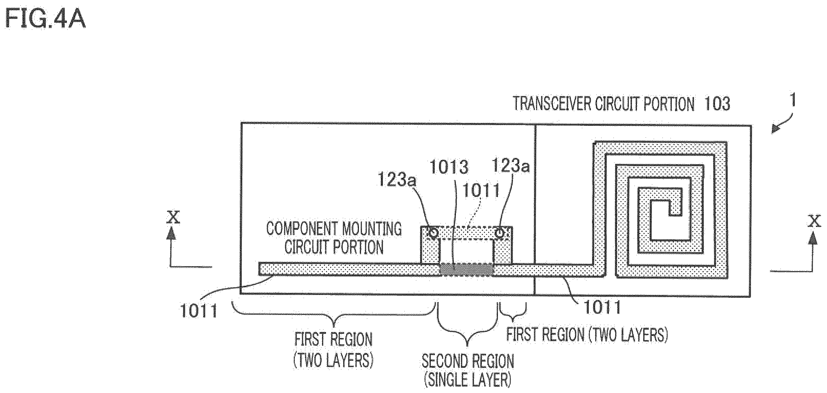

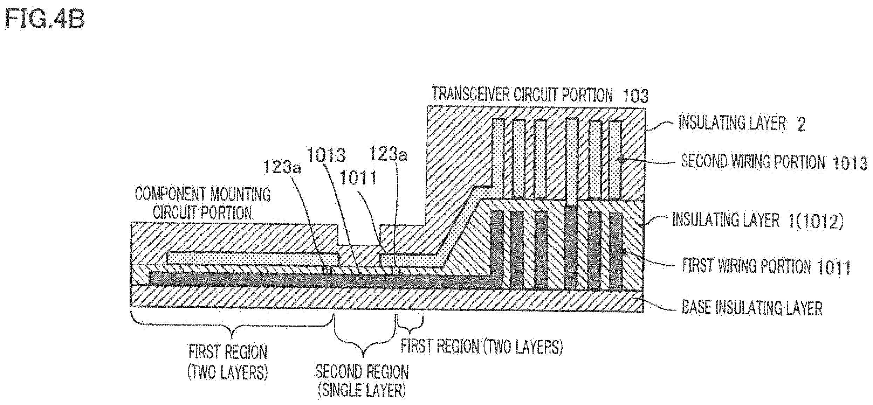

To be more specific, as shown in FIG. 4A and FIG. 4B, when the first region 101, the second region 102, and the first region 101 are provided in series in the transceiver circuit portion 103, the first wiring portions 1011 of the first region 101 are connected to one end of the coil of the transceiver circuit portion 103, whereas the second wiring portions 1013 of the first region 101 are connected to the other end of the coil. In the second region 102 sandwiched between the first regions 101, the first wiring portion 1011 and the second wiring portion 1013 are provided on the same flat plane. The first wiring portion 1011 and the second wiring portion 1013 of the second region 102 are electrically connected to the first wiring portion 1011 and the second wiring portion 1013 of the first region 101 through the conductive portion 123a. With this arrangement, in the wireless power supply wiring circuit board 1 shown in FIG. 4A and FIG. 4B, for example, an electromagnetic wave received by the coil portion of the transceiver circuit portion 103 can be converted to AC power and sent to the first wiring portion 1011 and the second wiring portion 1013 of the first region 101 and the second region 102 with currents and voltages suitable for the respective portions. Furthermore, as the second region 102 is set as the bending portion 130, the wireless power supply wiring circuit board 1 is bendable with small force at the second region 102.

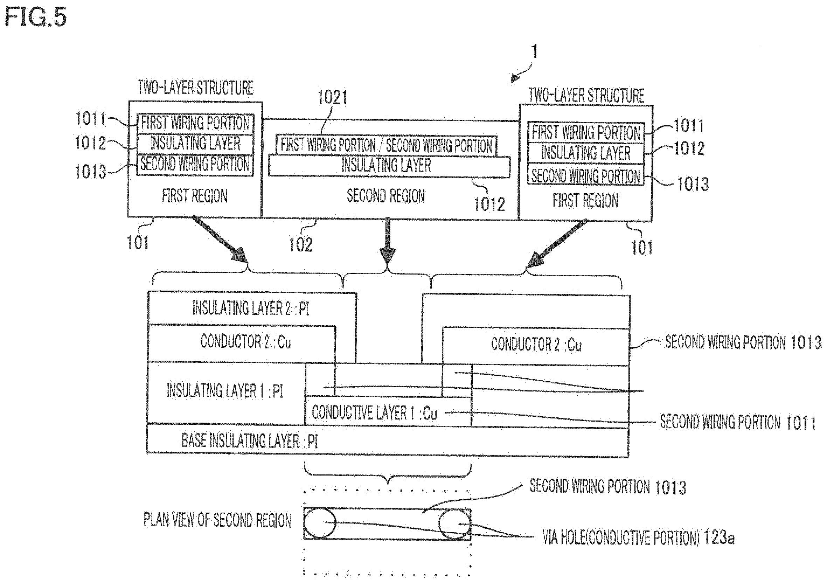

As shown in FIG. 5, the wireless power supply wiring circuit board 1 may be arranged such that, in the first region 101 in the vicinity of the bending portion 130, the first wiring portion 1011 is electrically connected by a via hole that is a conductive portion 123a. Because in this case the first wiring portion 1011 and the second wiring portion 1013 are connected to each other on the same flat plane in the bending portion 130, it is possible to supply same signals and currents to the first wiring portion 1011 and the second wiring portion 1013, respectively.

The second region 102 of the wireless power supply wiring circuit board 1 preferably falls within a range of 0.2 mm to 2 mm in width, and the wireless power supply wiring circuit board 1 preferably falls within a range of 30 $\mu$m to 100 $\mu$m in thickness.

AS shown in, for example, FIG. 3, the wireless power supply wiring circuit board 1 preferably includes a supporting layer 126 made of metal at least at a part of the first region 101. In this case, because the rigidity of the first region 101 is improved by the metal supporting layer 126, the rigidity of the entire board 1 is improved. The supporting layer 126 preferably falls within a range of 1 $\mu$m to 100 $\mu$m in thickness.

(Wireless Power Supply Wiring Circuit Board of Second Embodiment)

The following will describe Second Embodiment of the present invention with reference to drawings. Members identical with those of First Embodiment will be denoted by the same reference numerals.

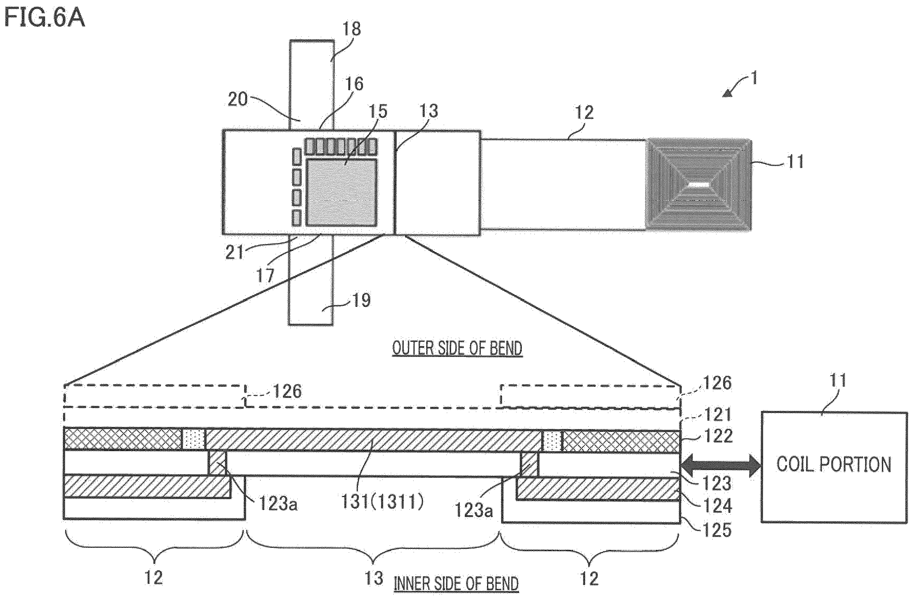

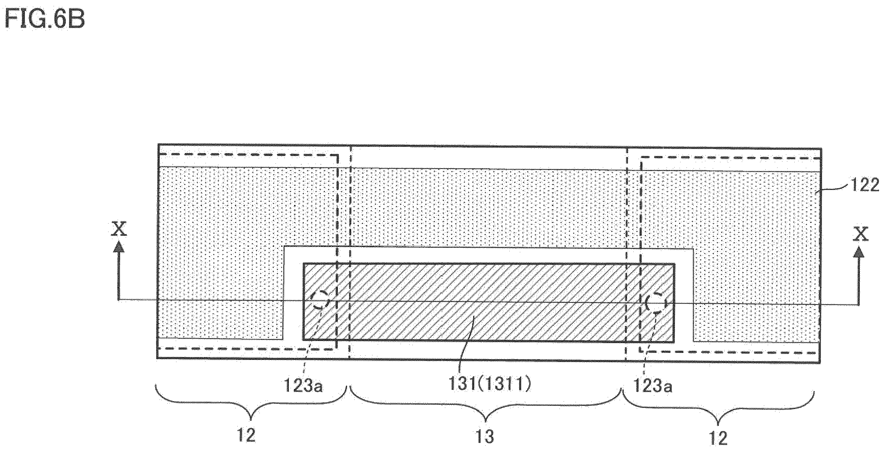

As shown in FIG. 6A and FIG. 6B, the wireless power supply wiring circuit board 1 includes a coil portion 11 configured to convert an electromagnetic wave to AC power, a first wiring portion 12 which is connected to the coil portion 11 and in which two conductive layers 122 and 124 receiving the AC power are stacked, and a first bending portion 13 which is provided to traverse the first wiring portion 12 and causes the inner side of the bend of the first wiring portion 12 to be recessed. The first bending portion 13 includes a first bending conductive layer 131 in which a conductive layer 124 formed on the inner side of the bend of the first wiring portion 12 is integrated with a conductive layer 122 formed on the outer side of the bend of the first wiring portion 12.

The phrase "formed to traverse the first wiring portion 12" indicates that something is formed across the entire width of the first wiring portion 12. The width of the first wiring portion 12 indicates the length in the direction orthogonal to the traveling direction of a current flowing in the conductive layers 122 and 124 of the first wiring portion 12. The direction of traversing the first wiring portion 12 may be identical with or inclined from the width direction of the first wiring portion 12. In other words, the first bending portion 13 may be formed to traverse the first wiring portion 12 in the width direction or may be formed to traverse the first wiring portion 12 in an oblique direction. In First Embodiment, the term "traverse" indicates a state in which the second region 102 is sandwiched between two first regions 101.

The direction of traversal may be linear or curved. When the first bending portion 13 linearly traverses the first wiring portion 12, it is possible to bend both the first wiring portion 12 on one side of the first bending portion 13 and the first wiring portion 12 on the other side of the first bending portion 13, in a planar manner. When the first bending portion 13 traverses the first wiring portion 12 in a curved manner, if the first wiring portion 12 on one side of the first bending portion 13 is bended in a planar manner, the first wiring portion 12 on the other side can be bended to be curved in the width direction in a three-dimensional manner. The direction of traversal may be zigzag and have one or more apex at an intermediate portion in the width direction. In this case, if the first wiring portion 12 on one side of the first bending portion 13 is arranged in a planar manner, the first wiring portion 12 on the other side can be bended to be three-dimensional with an apex. It is therefore possible to bend and attach the wireless power supply wiring circuit board 1 to attachment objects with various shapes.

The inner side of the bend is a side on which compression force is generated when the first wiring portion 12 is bended. The outer side of the bend is a side on which tensile force is generated when the first wiring portion 12 is bended. A portion where neither compression force nor tensile force is generated when the first wiring portion 12 is bended is a neutral plane. The recess is such a shape that a recess is formed as the first bending portion 13 is thinner than the neighboring first wiring portions 12 on the respective sides. To cause the inner side of the bend to be recessed is a state in which, when viewed in the direction of traversing the first wiring portion 12, the surface on the inner side of the bend of the first bending portion 13 is on the outer side of the bend of the surface on the inner side of the bended first wiring portion 12.

To integrate a conductive layer 124 formed on the inner side of the bend of the first wiring portion 12 with a conductive layer 122 formed on the outer side of the bend of the first wiring portion 12 indicates that the conductive layers 122 and 124 are made into a single first bending conductive layer 131 while maintaining electrical connection between the first bending conductive layer 131 and the conductive layers 122 and 124 of the first wiring portion 12. To put it differently, in the first bending portion 13, a conductive layer 124 on the inner side of the bend is removed from the conductive layers 122 and 124 of the neighboring first wiring portion 12, the first bending portion 13 has a first bending conductive layer 131 in which the removed conductive layer 123 is, as an additional conductive layer 1311, formed on the same flat plane as the conductive layer 122 on the outer side of the bend, and the additional conductive layer 1311 of the first bending conductive layer 131 is connected to the conductive layer 124 on the inner side of the bend of the neighboring first wiring portion 12 while being electrically separated from the conductive layer 122. With this arrangement, even when a current in a reverse direction or an alternate current with a different voltage flows in the conductive layers 122 and 124, it is possible to allow an alternate current to flow in the two conductive layers 122 and 124 over the entire first wiring portion 12.

In this way, in the wireless power supply wiring circuit board 1, because the inner side of the bend of the first bending portion 13 formed to traverse the first wiring portion 12 is arranged to be recessed, the length (thickness) in the curved direction (stacking direction) of the first bending portion 13 in a vertical cross section in the width direction is shorter than the length (thickness) in the curved direction of the first wiring portion 12 excluding the first bending portion 13. On this account, the rigidity of the first bending portion 13 is low due to a small section modulus. In this connection, because the first bending portion 13 and the first wiring portion 12 are rectangular in cross section, the rigidity decreases in proportion to the second power of the length (thickness) in the curved direction (stacking direction). On this account, even though only one conductive layer 122 is removed from the first wiring portion 12 as a difference in thickness, the rigidity of the first bending portion 13 is significantly lowered as compared to that of the first wiring portion 12. Consequently, in the wireless power supply wiring circuit board 1, the bendability that indicates easiness of bending is high at the first bending portion 13. As the first bending portion 13 is set as a position to be bended, it is possible to bend the wireless power supply wiring circuit board 1 with small force even when the wireless power supply wiring circuit board 1 is significantly downsized.

In the first bending conductive layer 131 of the first bending portion 13, the conductive layer 124 on the inner side of the bend of the first wiring portion 12 is integrated with the conductive layer 122 on the outer side of the bend of the first wiring portion 12. On this account, the first wiring portion 12 on one side of the first bending portion 13 and the first wiring portion 12 on the other side of the first bending portion 13 are not electrically disconnected due to the presence of the first bending portion 13, and the two conductive layers 122 and 124 are connected in the entirety of the first wiring portion 12. As a result, even when, for example, one terminal of the coil portion 11 is connected to the conductive layer 122 on the outer side of the bend and the other terminal is connected to the conductive layer 124 on the inner side of the bend, AC power (alternate current) generated by the coil portion 11 can be supplied from the first wiring portion 12 on the one side connected to the coil portion 11 to the first wiring portion 12 on the other side. On this account, the wireless power supply wiring circuit board 1 has good bendability thanks to the first bending portion 13, and even when the first bending portion 13 traverses the first wiring portion 12, the two conductive layers 122 and 124 are electrically connected across the entirety of the first wiring portion 12 from the one side to the other side.

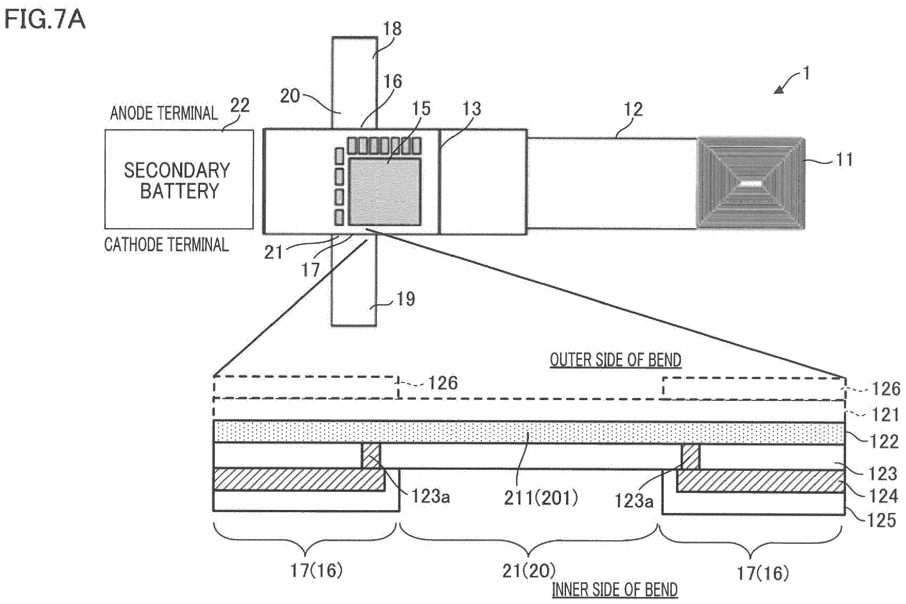

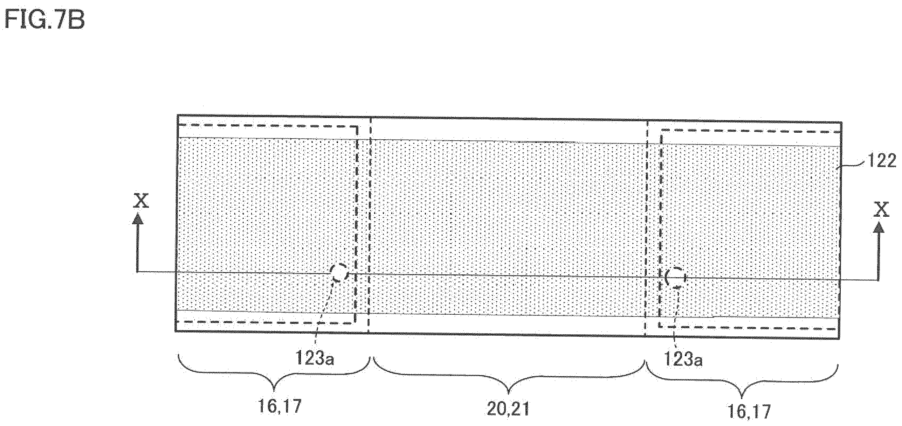

In addition to the above, as shown in FIG. 7A and FIG. 7B, the wireless power supply wiring circuit board 1 includes: second wiring portions 16 and 17 in which two conductive layers 122 and 124 receiving a direct current of the secondary battery 22 are stacked; and second bending portions 20 and 21 which are provided to traverse the second wiring portions 16 and 17 and cause the inner side of the bend of each of the second wiring portions 16 and 17 to be recessed. The second bending portions 20 and 21 include second bending conductive layers 201 and 211 in which a conductive layer 124 formed on the inner side of the bend of the second wiring portions 16 and 17 is integrated with a conductive layer formed on the outer side of the bend of the second wiring portions 16 and 17.

In the second bending conductive layers 201 and 211, because a current (DC power) discharged from the secondary battery 22 flows at the same voltage and in the same direction, the conductive layers 122 and 124 are electrically connected to each other. Being similar to the arrangements shown in FIG. 6A and FIG. 7B, the second bending conductive layers 201 and 211 may include an additional conductive layer 1311 that is electrically separated from the conductive layer 122. The second bending portions 20 and 21 in which DC power flows may therefore be arranged so that the conductive layers 122 and 124 are electrically connected to each other or separated from each other. Except this, the second bending portions 20 and 21 are structurally identical with the first bending portion 13.

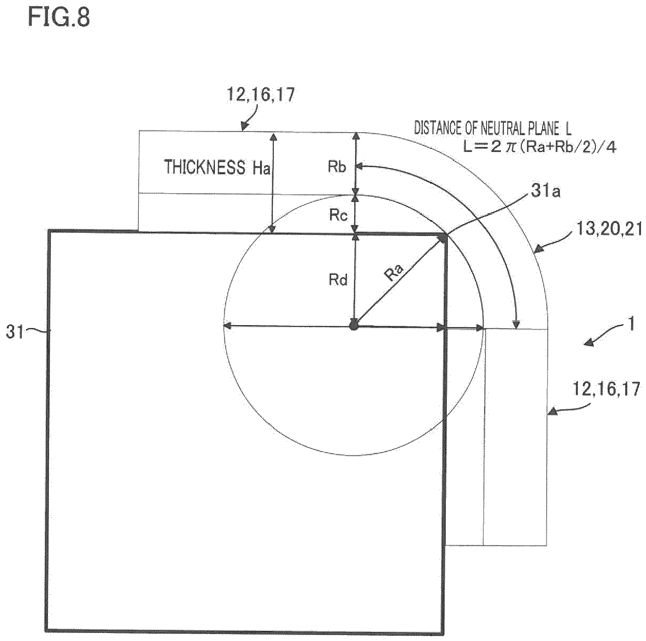

As shown in FIG. 8, preferably, the thickness Rb of the first bending portion 13 and the second bending portions 20 and 21, the curvature radius Ra of the neutral plane of the first bending portion 13 and the second bending portions 20 and 21, and the distance L of the neutral plane satisfy the relationship of $L=2\pi (Ra+Rb/2)/4$. When this relationship is satisfied, in a case in which a bending target 31 of the wireless power supply wiring circuit board 1 has a corner portion 31a that is bended at right angles and the wireless power supply wiring circuit board 1 is bended along the corner portion 31a, the both end portions of the first bending portion 13 and the second bending portions 20 and 21 can be provided on the respective sides of the corner portion 31a while the corner portion 31a is made in contact with the central portion of the surface on the inner side of the bend of each of the first bending portion 13 and the second bending portions 20 and 21. This makes it easy to position the first bending portion 13 and the second bending portions 20 and 21, and to design the bending angle because the planar direction of the first bending portion 13 and the second bending portions 20 and 21 is arranged to be identical with the planar direction of the first wiring portion 12 and the second wiring portions 16 and 17 at a border portion.

Preferably, the thickness Ha of the first wiring portion and the second wiring portion, the thickness Rb of the first bending portion 13 and the second bending portions 20 and 21, and the distance L of the neutral plane of the first bending portion 13 and the second bending portions 20 and 21 satisfy the relationship of Ha=0.85Rb+0.6L/$\pi$. This makes it easy to calculate the depth of the recess of the first bending portion 13 and the second bending portions 20 and 21 and the thickness of each layer when the corner portion 31a of the bending target 31 is made contact with the central portion of the surface on the inner side of the bend of each of the first bending portion 13 and the second bending portions 20 and 21.

The distance L of the neutral plane is calculated as follows.

When the corner portion (bended at right angles) of the bending target is made contact with the central portion of the surface on the inner side of the bend of the bending portion, the curvature radius Ra when the bending portion is bended at a curvature of 90 degrees, the thickness Rb of the bending portion, and the distance L of the neutral plane satisfy a relational expression (1) below.

$$L=2\pi(Ra+Rb/2)/4 \quad \ldots \quad (1)$$

The distance Rd from the origin of the curvature radius Ra in the direction orthogonal to the inner side surface of the bending portion and the curvature radius Ra are expressed by the following relational expression (2).

$$Rd=Ra\sin45°=0.7Ra \quad \ldots \quad (2)$$

In this expression, an approximation of sin45° is 0.7.

The following relational expression (3) expresses the curvature radius Ra by rearranging the relational expression (1) of the distance L of the neutral plane.

$$Ra=4L/2\pi-Rb/2 \quad \ldots \quad (3)$$

The depth Rc of the bending portion is calculated as follows.

The depth of the bending portion is calculated by subtracting the distance Rd from the curvature radius Ra. The following relational expression (4) expresses the depth Rc=Ra-Rd by using the relational expressions (2) and (3).

$$\text{Depth } Rc=Ra-Rd=Ra-Ra\sin45°$$

$$=0.3Ra$$

$$=0.3(4L/2\pi-Rb/2)$$

$$=0.6L/\pi-0.15Rb \quad \ldots \quad (4)$$

The thickness Ha of the board is calculated as follows.

The thickness Ha of the board, the thickness Rb of the bending portion, and the depth Rc of the recess are expressed by the following relational expression.

$$Ha=Rb+Rc \quad \ldots \quad (5)$$

The relational expression (4) indicating that the depth Rc=0.6L/$\pi$-0.15Rb is substituted for Rc of the relational expression (5) and the resultant expression is adjusted.

$$\text{Thickness } Ha \text{ of the board}$$

$$=Rb+Rc$$

$$=Rb+0.3Ra$$

$$=Rb+0.3(4L/2\pi-Rb/2)$$

$$=0.85Rb+0.6L/\pi$$

The relational expressions are those of a case where the wireless power supply wiring circuit board 1 is bended at a curvature of 90 degrees. The disclosure, however, is not limited to these expressions. When the board is bended at a curvature (bending angle) different from 90 degrees, the bending angle is set at $\theta$.

Preferably, the distance L of the first bending portion 13 and the second bending portions 20 and 21 falls within a range of 0.2 mm to 2 mm, and the thickness Ha of the first wiring portion 12 and the second wiring portions 16 and 17 falls within a range of 30 $\mu$m to 100 $\mu$m. This is because, when, in regard to the wiring distance of the bending portion, the lower limit of the distance L is set at 0.2 mm and the upper limit of the distance L is set at 2 mm, electric properties are sufficient and at the same time downsizing is achieved. Furthermore, when, in regard to the thickness of the board, the lower limit of the thickness Ha is set at 30 μm and the upper limit of the thickness Ha is set at 100 μm, the strength is sufficient and at the same time thinning is achieved.

In addition to the above, as shown in FIG. 6A and FIG. 7A, the first wiring portion 12 and the second wiring portions 16 and 17 preferably include a supporting layer 126 made of metal. In this case, because the supporting layer 126 exists on the both sides of the first bending portion 13 and the second bending portions 20 and 21, the strength of the surroundings of the first bending portion 13 and the second bending portions 20 and 21 is improved, and hence the strength of the first bending portion 13 and the second bending portions 20 and 21 is improved. As a result, deformation at the time of the bending is reduced and the bending becomes easy. The supporting layer 126 may be provided on the inner side or the outer side of the bend. The material of the supporting layer 126 is preferably stainless steel in consideration of the strength and corrosion resistance.

The supporting layer 126 preferably falls within a range of 1 μm to 100 μm in thickness. This is because, when the thickness falls within the range of 1 μm to 100 μm, both the reinforcement and downsizing are achieved.

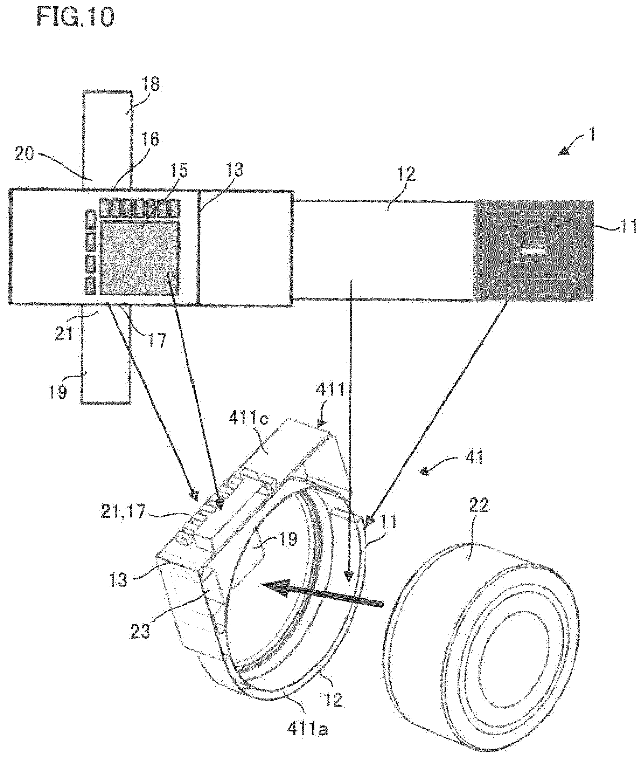

The wireless power supply wiring circuit board 1 may form a battery module 41 shown in FIG. 10, which is connected to the secondary battery 22 and is arranged so that the distance between the second bending portions 20 and 21 to the secondary battery 22 falls within a range of 0.01 mm to 1.0 mm. When the distance falls within the range of 0.01 mm to 1.0 mm, downsizing is achieved without interference with other components, and suppression of connection failure and high positioning precision are achieved.

(Specific Example of Wireless Power Supply Wiring Circuit Board)

The following shows a specific example in which the wireless power supply wiring circuit board 1 arranged as described above is used as a battery module 41 mounted on a mobile device.

The mobile device encompasses a handheld device which can be carried on a hand and a human-wearable device which can be worn a human body. Specific examples of the mobile device include a portable computer (a laptop PC, a note PC, a tablet PC, or the like), a camera, an audio visual device (a portable music player, an IC recorder, a portable DVD player, or the like), a calculator (such as a pocket computer and an electronic calculator), a game console, a computer peripheral (a portable printer, a portable scanner, a portable modem, or the like), a dedicated information device (an electronic dictionary, an electronic notebook, an electronic book, a portable data terminal, or the like), a portable communication terminal, a voice communication terminal (a mobile phone, a PHS, a satellite phone, a third party radio system, an amateur radio, a specified low power radio, a personal radio, a citizen radio, or the like), a data communication terminal (a portable phone, a PHS (a feature phone and a smart phone), a pager, or the like), a broadcasting receiver (a television receiver and a radio), a portable radio, a portable television receiver, a one-seg receiver, another type of device (a wristwatch and a pocket watch), a hearing aid, a handheld GPS, a security buzzer, a flashlight/pen light, a battery pack, and the like. Examples of the above hearing aid include an ear-hook hearing aid, an ear hole fitting hearing aid, and a glasses-type hearing aid. The mobile device may have an IoT (Internet of Things) function.

As shown in FIG. 6A, the wireless power supply wiring circuit board 1 has a double-sided substrate structure and is strip-shaped. The double-sided substrate structure includes the supporting layer 126 that is the outermost surface on the outer side of the bend of the wireless power supply wiring circuit board 1, a base insulating layer 121 provided on the inner side of the insulating layer 126, a conductive layer 122 provided on the inner side of the base insulating layer 121, an insulating layer 123 provided on the inner side of the conductive layer 122, a conductive layer 124 provided on the inner side of the insulating layer 123, and an insulating layer 125 provided on the inner side of the conductive layer 124.

The supporting layer 126 is made of, in addition to the stainless steel described above, a metal material such as copper, silver, gold, and nickel. Each of the base insulating layer 121 and the insulating layers 123 and 125 is made of polyimide resin. Alternatively, for example, these layers may be made of an insulative material such as synthetic resin such as polyamide-imide resin, acrylic resin, polyether nitrile resin, polyether sulfone resin, polyethylene terephthalate resin, polyethylene naphthalate resin, and polyvinyl chloride resin. The conductive layers 122 and 124 are, for example, made of conductive metal such as copper, silver, gold, nickel, solder, or alloy of these metals. The conductive layers 122 and 124 are preferably made of copper.

As shown in FIG. 6A and FIG. 7A, in the first wiring portion 12 and the second wiring portions 16 and 17, the first bending portion 13 and the second bending portions 20 and 21 are formed, respectively. The first bending portion 13 and the second bending portions 20 and 21 have a single-side substrate structure. The single-side substrate structure includes the base insulating layer 121 that is the outermost surface on the outer side of the bend, the first bending conductive layer 131 and the second bending conductive layers 201 and 211 provided on the inner side of the base insulating layer 121, and the insulating layer 123 provided on the inner side of the first bending conductive layer 131 and the second bending conductive layers 201 and 211. Both end portions of the first bending conductive layer 131 and the second bending conductive layers 201 and 211 in the direction in which a current flows are electrically connected to the conductive layer 124 on the inner side of the bend of the first wiring portion 12 and the second wiring portions 16 and 17, through conductive portions 123a formed in the insulating layer 123.

(Method of Manufacturing Wireless Power Supply Circuit Board)

The wireless power supply wiring circuit board 1 structured as described above is manufactured by a manufacturing method described below.

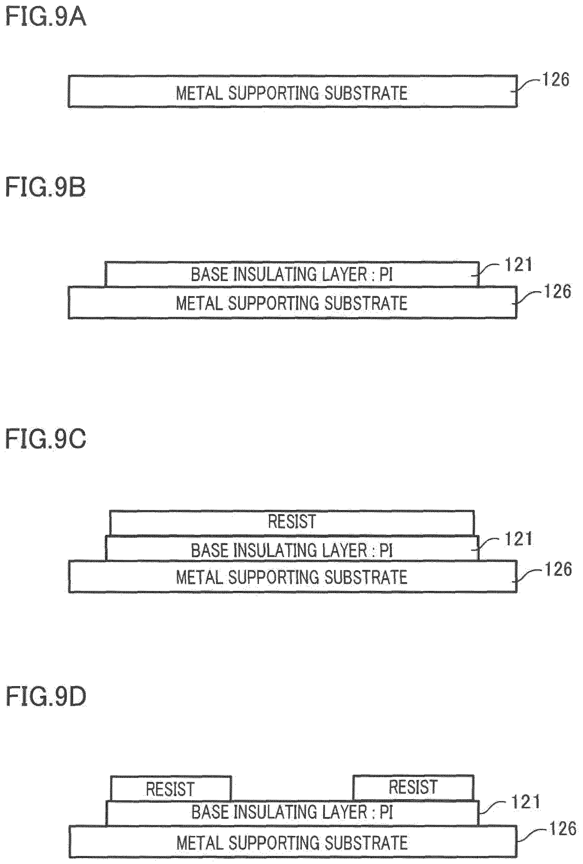

To begin with, a metal supporting plate made of stainless steel is prepared to be used as a supporting layer 126 (FIG. 9A). Subsequently, on the top surface of the metal supporting plate, varnish that is a photosensitive insulative material is applied and dried. As a result, a photosensitive base film is formed as a base insulating layer 121 (FIG. 9B). On the top surface of the base insulating layer 121, an unillustrated seed film is formed. Examples of a method of forming the seed film include sputtering, electrolytic plating, and electroless plating. The method is preferably sputtering. Examples of the material of the seed film include metals such as copper, chromium, and nickel, and alloy of these metals. On the top surface of the seed film, an etching resist is formed (FIG. 9C). Thereafter, a conductive pattern is formed by performing exposure and development (FIG. 9D).

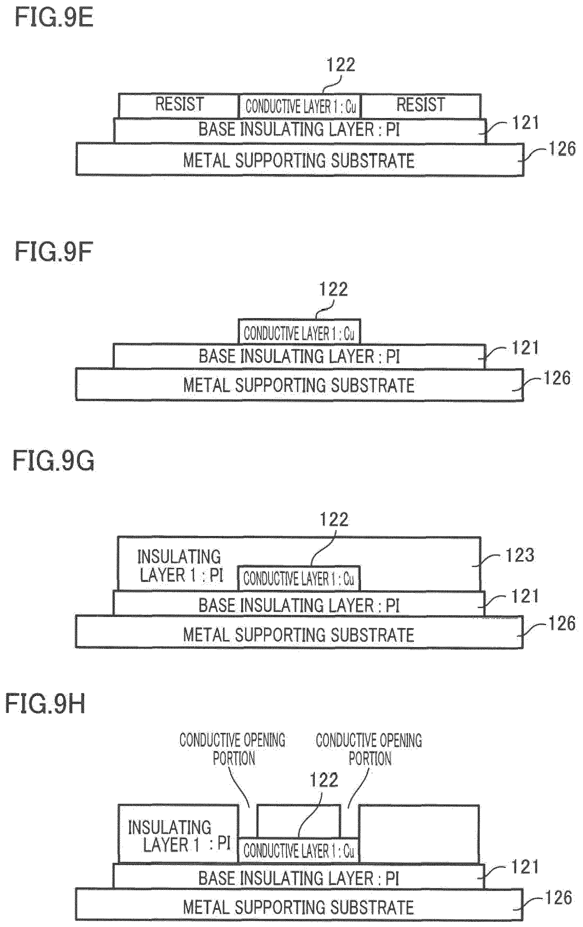

Subsequently, by an additive method such a plating, a conductive layer 122 is formed on the top surface of the base insulating layer 121 in which the seed film has been formed on the top surface (FIG. 9E). The resist is removed and the seed film on the bottom surface of the resist is removed by known etching (e.g., wet etching) (FIG. 9F). To the top surface of the base insulating layer 121 and the conductive layer 122, varnish that is a photosensitive insulative material is applied and dried. As a result, an insulating layer 123 that is a photosensitive insulating layer film is formed (FIG. 9G). Thereafter, the photosensitive insulative film (insulating layer 123) is exposed to light through a photomask, with the result that an opening portion is formed in the insulating layer 123 (FIG. 9H). The photomask has a pattern of a light blocking portion and a pattern of a light transmissive portion. At a part where the insulating layer 123 is to be formed, the light transmissive portion is provided to oppose the insulating layer 123. At a part where the opening portion is to be formed, the light blocking portion is provided to oppose the insulating layer 123. Thereafter, the insulating layer 123 after the exposure is developed and thermosetting is performed according to need. As a result, the opening portion is formed in the insulating layer 123. Then a seed film is formed on the opening portion of the insulating layer 123.

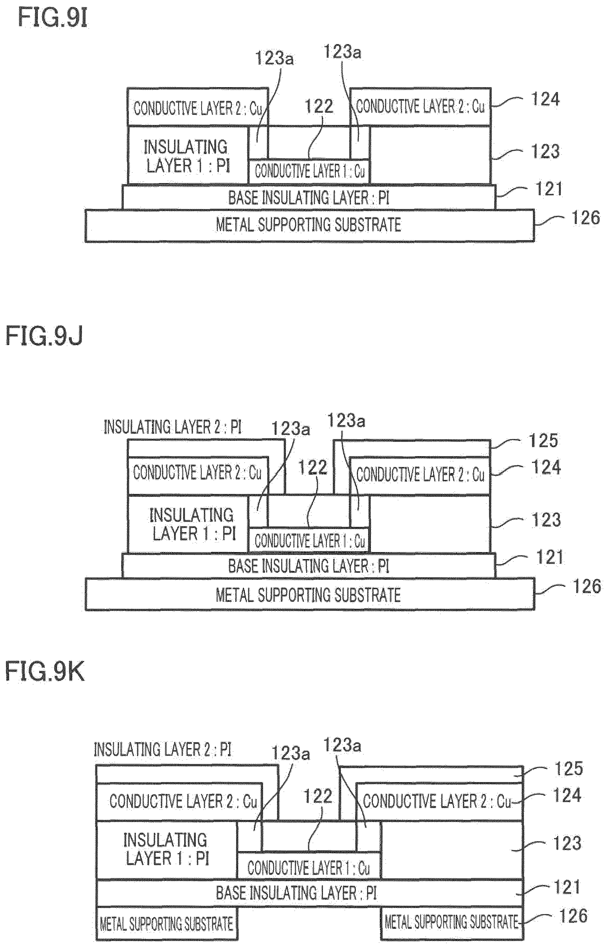

Subsequently, a conductive layer 124 is formed on the top surface of the insulating layer 123 where the seed film has been formed. At the same time, the opening portion is filled with a material of the conductive layer 124. In other words, the conductive layer 124 and the conductive portions 123a are simultaneously formed by an additive method such as plating. Although not illustrated, the conductive layer 124 is formed in such a way that, in the same manner as the conductive layer 122, a conductive pattern is formed by performing exposure and development of an etching resist. Thereafter, in the same manner as in conductive layer 122, the conductive layer 124 is formed and the resist is removed (FIG. 9I). Subsequently, the seed film on the top surface of the insulating layer 123 is removed and a cover insulating layer 125 is formed (FIG. 9J). Subsequently, the outer shape of the metal supporting plate that is the supporting layer 126 is processed (FIG. 9K). The processing of the outer shape is performed by, for example, forming a pattern on the metal supporting substrate by etching such as dry etching (e.g., plasma etching) and wet etching (e.g., chemical etching), drilling, or laser processing. The supporting layer is preferably formed by processing the outer shape of the metal supporting plate by wet etching.

(Method of Forming Battery Module by Using Wireless Power Supply Wiring Circuit Board)

As shown in FIG. 10, the wireless power supply wiring circuit board 1 includes the coil portion 11, the first wiring portion 12, and a mounting portion 15. On the side opposite to the mounting portion 15 over the first bending portion 13, the wireless power supply wiring circuit board 1 is provided with another component mounting portion 23. This mounting portion 23 is provided on the bottom surface side that is the secondary battery 22 side. The sections 11, 12, and 15 are provided in this order from one end portion in the longitudinal direction of the strip-shaped wireless power supply wiring circuit board 1. The mounting portion 15 includes members such as a connector or a metal terminal connected to an external device. Examples of the external device include a microphone and a speaker of a mobile device and a signal processing circuit component. On the surface of the mounting portion 15, digital processing electronic components are mainly mounted. Meanwhile, the mounting portion 23 on the bottom surface side mainly has analog processing electronic components. To be more specific, the mounting portion 23 on the bottom surface side has electronic components such as a rectifying circuit configured to convert an alternate current generated by the coil portion 11 to a direct current, an integrated circuit such as a voltage-transformation circuit configured to transform a voltage of a discharging current (direct current) of the secondary battery 22 to a driving voltage of the external device, a resistor, and a capacitor. The voltage-transformation circuit includes electronic components such as a resistor, a capacitor, and an inductor. The voltage-transformation circuit may be provided at the mounting portion 15. The mounting portion 23 further includes electronic components such as an integrated circuit such as a charging circuit configured to control the charging of the secondary battery 22, a resistor, and a capacitor. At both end portions in the width direction of the mounting portion 15, electrode terminal portions 18 and 19 are provided through the intermediary of second wiring portions 16 and 17. The electrode terminal portions 18 and 19 are electrically connected to a positive electrode terminal and a negative electrode terminal, respectively. The positive electrode terminal and the negative electrode terminal are on one surface and the other surface of a button-shaped secondary battery 22, respectively.

The secondary battery 22 may be of any type as long as it is rechargeable. Various types of batteries including solid-state batteries may be employed as the secondary battery 22 in accordance with the type of the portable device 2. The secondary battery 22 is preferably a lithium ion battery. The nominal voltage of the lithium ion battery which falls within a range of 3.6V to 3.7V is higher than the nominal voltages of 1.2V to 1.4V of the air battery or the nickel-hydrogen secondary battery 22. Although the lithium ion battery exhibits a discharge characteristic such that its battery voltage drops from approximately 4.2V to approximately 2.7V, the lithium ion battery is able to drive the portable device 2 longer than the air battery or the nickel-hydrogen secondary battery 22, because the energy density of the lithium ion battery is higher than that of the air battery or the nickel-hydrogen secondary battery 22.

In the first wiring portion 12 and the second wiring portions 16 and 17, the first bending portion 13 and the second bending portions 20 and 21 that have a single-side substrate structure are formed, respectively. As the wireless power supply wiring circuit board 1 is bended at the first bending portion 13 and the second bending portions 20 and 21, a battery module 41 including the secondary battery 22 is formed.

To be more specific, the battery module 41 includes a housing 411 in which a button-shaped secondary battery 22 is accommodated. The housing 411 has a peripheral wall 411a supporting the side peripheral surface of the secondary battery 22 and a flat portion 411c that is formed by partially flattening the peripheral wall 411a so that the mounting portion 15 is provided in a planar manner. When the wireless power supply wiring circuit board 1 is attached to the housing 411 accommodating the secondary battery 22, to begin with, the first bending portion 13 of the wireless power supply wiring circuit board 1 is positioned and made contact to an end portion of the flat portion 411c of the housing 411, and then the circuit board 1 is bended at this first bending portion 13 at right angles. As a result of this, the first wiring portion 12 and the coil portion 11 on one side of the first bending portion 13 are provided along the peripheral wall 411a of the housing 411, whereas the mounting portion 15 on the other side of the first bending portion 13 is provided along the flat portion 411c of the housing 411. In this way, the coil portion 11 and the mounting portion 15 are highly precisely positioned at predetermined positions of the housing 411. Thereafter, as the electrode terminal portions 18 and 19 are bended at the second bending portions 20 and 21 at right angles, the electrode terminal portions 18 and 19 are connected to the electrodes of the secondary battery 22. In this regard, the bending at the first bending portion 13 and the second bending portions 20 and 21 can be easily done with small pressing force, because the inner side of the bend of each of the first bending portion 13 and the second bending portions 20 and 21 is arranged to be recessed in shape as described above.

(Modifications of Wireless Power Supply Wiring Circuit Board)

While in the descriptions above the wireless power supply wiring circuit board 1 is a double-sided board having two conductive layers 122 and 124, the disclosure is not limited to this arrangement. The board 1 may be a multilayer substrate having two or more conductive layers. That is to say, the wireless power supply wiring circuit board 1 may include a wiring portion in which plural conductive layers are stacked and a bending portion which is formed to traverse the wiring portion and includes a bending portion with which the inner side of the bend of the wiring portion is arranged to be recessed, and at least one conductive layer of the conductive layers of the wiring portion may be arranged to be a bending conductive layer in which the at least one conductive layer is integrated with the remaining conductive layers. The use of the multilayer substrate having the bending conductive layer is not limited to wireless power supply. The multilayer substrate may be used for a typical printed wiring board.

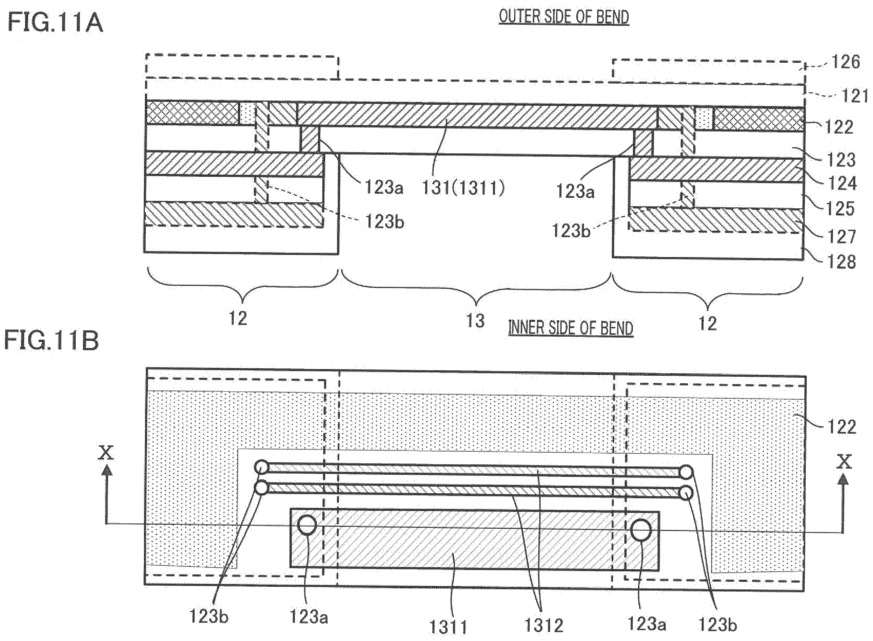

The following will describe a case where the first wiring portion 12 has three conductive layers, with reference to FIG. 11A and FIG. 11B. The wireless power supply wiring circuit board 1 includes a supporting layer 126 that is the outermost surface on the outer side of the bend, a base insulating layer 121 provided on the inner side of the insulating layer 126, a conductive layer 122 provided on the inner side of the base insulating layer 121, an insulating layer 123 provided on the inner side of the conductive layer 122, a conductive layer 124 provided on the inner side of the base insulating layer 123, an insulating layer 125 provided on the inner side of the conductive layer 124, a conductive layer 127 provided on the inner side of the insulating layer 125, and an insulating layer 128 provided on the inner side of the conductive layer 127.

In the first wiring portion 12, a first bending portion 13 is formed. The first bending portion 13 has a single-side substrate structure. The single-side substrate structure includes the base insulating layer 121 that is the outermost surface on the outer side of the bend, a first bending conductive layer 131 provided on the inner side of the base insulating layer 121, and the insulating layer 123 provided on the inner side of the first bending conductive layer 131. On the inner side of the base insulating layer 121, additional conductive layers 1311 and 1312 are provided. Both end portions of the first bending conductive layer 131 and the additional conductive layers 1311 and 1312 in the direction in which a current flows are electrically connected to the conductive layer 124 and the conductive layer 127 on the inner side of the bend of the first wiring portion 12 through the conductive portions 123a and the conductive portions 123b.

Although the above descriptions have been provided with regard to the characteristic parts so as to understand the invention more easily, the invention is not limited to the embodiment as described above and can be applied to the other embodiments and the applicable scope should be construed as broadly as possible. Furthermore, the terms and phraseology used in the specification have been used to correctly illustrate the present invention, not to limit it. In addition, it will be understood by those skilled in the art that the other structures, systems, methods and the like included in the spirit of the present invention can be easily derived from the spirit of the invention described in the specification. Accordingly, it should be considered that the present invention covers equivalent structures thereof without departing from the spirit and scope of the invention as defined in the following claims. In addition, it is required to sufficiently refer to the documents that have been already disclosed, so as to fully understand the objects and effects of the present invention.

**Claims**

1. A wireless power supply wiring circuit board comprising:

   a first region which includes an insulating layer, a first wiring portion provided on one surface side in a thickness direction of the insulating layer, and a second wiring portion provided on the other side in the thickness direction of the insulating layer;
   a second region in which the first wiring portion and the second wiring portion are provided on a same flat plane;
   a transceiver circuit portion; and a component mounting circuit portion which is electrically connected to the transceiver circuit portion.

2. The wireless power supply wiring circuit board according to claim 1, wherein, the second region is a bending portion.

3. The wireless power supply wiring circuit board according to claim 2, wherein, in the first region in vicinity of the bending portion, the first wiring portion is provided on a same flat plane as the second wiring portion on account of a via hole.

4. The wireless power supply wiring circuit board according to claim 2, wherein, in the first region in vicinity of the bending portion, the first wiring portion is electrically connected to the second wiring portion by a via hole.

5. The wireless power supply wiring circuit board according to any one of claims 1 to 4, wherein,

   the second region is arranged to fall within a range of 0.2 mm to 2 mm in width, and
   the wireless power supply wiring circuit board falls within a range of 30 $\mu$m to 100 $\mu$m in thickness.

6. The wireless power supply wiring circuit board according to any one of claims 1 to 5, further comprising a supporting layer that is made of metal and is provided at least at a part of the first region.

7. The wireless power supply wiring circuit board according to claim 6, wherein, the supporting layer falls within a range of 1 $\mu$m to 100 $\mu$m in thickness.

## FIG.1A

THICKNESS DIRECTION

| FIRST WIRING PORTION |
| 1011 |
| INSULATING LAYER |
| 1012 |
| SECOND WIRING PORTION |
| 1013 |

FIRST REGION

101

FIRST WIRING PORTION / SECOND WIRING PORTION
1021

INSULATING LAYER
1012

SECOND REGION

102

TRANSCEIVER CIRCUIT PORTION

103

COMPONENT MOUNTING CIRCUIT PORTION

104

1

## FIG.1B

THICKNESS DIRECTION

TWO-LAYER STRUCTURE

FIRST WIRING PORTION — 1011
INSULATING LAYER — 1012
SECOND WIRING PORTION — 1013

FIRST REGION

101

1021

FIRST WIRING PORTION / SECOND WIRING PORTION
INSULATING LAYER

SECOND REGION

102   1012

## FIG.1C

THICKNESS DIRECTION

TWO-LAYER STRUCTURE

FIRST WIRING PORTION — 1011
INSULATING LAYER — 1012
SECOND WIRING PORTION — 1013

FIRST REGION

101

1012

INSULATING LAYER
FIRST WIRING PORTION / SECOND WIRING PORTION

SECOND REGION

102   1021

FIG.1D

FOUR-LAYER STRUCTURE 1011

FIRST WIRING PORTION 1014
INSULATING LAYER 1015
THIRD WIRING PORTION 1016
INSULATING LAYER 1016
FOURTH WIRING PORTION 1017
INSULATING LAYER 1013
SECOND WIRING PORTION

FIRST REGION

101

FIRST WIRING PORTION / SECOND WIRING PORTION 1021
INSULATING LAYER 1014
THIRD WIRING PORTION 1015
INSULATING LAYER 1012
FOURTH WIRING PORTION 1016

SECOND REGION

102

FIRST WIRING PORTION / SECOND WIRING PORTION / THIRD WIRING PORTION 1021
INSULATING LAYER 1012
FOURTH WIRING PORTION 1016

SECOND REGION

102

FIRST WIRING PORTION / SECOND WIRING PORTION / THIRD WIRING PORTION / FOURTH WIRING PORTION
INSULATING LAYER 1016
1021

SECOND REGION

102

14

FIG.2A

WIDTH
DIRECTION

| FIRST REGION | SECOND REGION | TRANSCEIVER CIRCUIT PORTION | COMPONENT MOUNTING CIRCUIT PORTION |
| --- | --- | --- | --- |
| 101 | 102 | 103 | 104 |

1

FIG.2B

WIDTH
DIRECTION

| COMPONENT MOUNTING CIRCUIT PORTION | FIRST REGION | SECOND REGION | FIRST REGION | TRANSCEIVER CIRCUIT PORTION |
| --- | --- | --- | --- | --- |
| 104 | 101 | 102 | 101 | 103 |

1

FIG.2C

WIDTH
DIRECTION

101

| COMPONENT MOUNTING CIRCUIT PORTION | FIRST REGION | SECOND REGION | FIRST REGION | TRANSCEIVER CIRCUIT PORTION |
| --- | --- | --- | --- | --- |
| 104 | | 102 | 101 | 103 |

SECOND REGION —102

FIRST REGION —101

COMPONENT MOUNTING CIRCUIT PORTION —103

1

# FIG.3

TWO-LAYER STRUCTURE

1011 — FIRST WIRING PORTION
1012 — INSULATING LAYER
1013 — SECOND WIRING PORTION

FIRST REGION

101

1021

FIRST WIRING PORTION / SECOND WIRING PORTION
INSULATING LAYER

SECOND REGION

1012

102

TWO-LAYER STRUCTURE

FIRST WIRING PORTION — 1011
INSULATING LAYER — 1012
SECOND WIRING PORTION — 1013

FIRST REGION

101

INSULATING LAYER 2 : PI

CONDUCTOR 2 : Cu

INSULATING LAYER 1 : PI

CONDUCTOR 2 : Cu — SECOND WIRING PORTION 1013

VIA HOLE (CONDUCTIVE PORTION) 123a

CONDUCTIVE LAYER 1 : Cu

SECOND WIRING PORTION 1011

BASE INSULATING LAYER : PI

SECOND WIRING PORTION 1013

VIA HOLE (CONDUCTIVE PORTION) 123a

PLAN VIEW OF SECOND REGION

FIRST WIRING PORTION 1011

EP 4 057 305 A1

FIG.4A

# FIG.4B

TRANSCEIVER CIRCUIT PORTION  103

COMPONENT MOUNTING
CIRCUIT PORTION

123a  1013  123a
      1011

INSULATING LAYER  2

SECOND WIRING PORTION  1013

INSULATING LAYER  1(1012)

FIRST WIRING PORTION  1011

BASE INSULATING LAYER

FIRST REGION
(TWO LAYERS)

SECOND REGION
(SINGLE LAYER)

FIRST REGION (TWO LAYERS)

EP 4 057 305 A1

FIG.5

SECOND WIRING PORTION 1013
SECOND WIRING PORTION 1011
SECOND WIRING PORTION 1013
VIA HOLE(CONDUCTIVE PORTION) 123a

FIG.6A

OUTER SIDE OF BEND

INNER SIDE OF BEND

COIL PORTION

FIG.6B

123a 131(1311) 123a

12 13 12

EP 4 057 305 A1

# FIG.7A

ANODE TERMINAL 22

SECONDARY BATTERY

CATHODE TERMINAL

OUTER SIDE OF BEND

126

126

121

122

211(201)

123a                                        123a

123

124

125

17(16)                    21(20)                    17(16)

INNER SIDE OF BEND

EP 4 057 305 A1

FIG.7B

123a

123a

16,17

20,21

16,17

122

EP 4 057 305 A1

FIG.8

12,16,17

DISTANCE OF NEUTRAL PLANE L
$L=2\pi(Ra+Rb/2)/4$

THICKNESS Ha

Rb

Rc

31a

13,20,21

Rd

Ra

1

31

12,16,17

FIG.9A

METAL SUPPORTING SUBSTRATE ~126

FIG.9B

BASE INSULATING LAYER : PI ~121
METAL SUPPORTING SUBSTRATE ~126

FIG.9C

RESIST
BASE INSULATING LAYER : PI ~121
METAL SUPPORTING SUBSTRATE ~126

FIG.9D

RESIST          RESIST
BASE INSULATING LAYER : PI ~121
METAL SUPPORTING SUBSTRATE ~126

## FIG.9E

122

| RESIST | CONDUCTIVE LAYER 1 : Cu | RESIST |

BASE INSULATING LAYER : PI — 121

METAL SUPPORTING SUBSTRATE — 126

## FIG.9F

122

CONDUCTIVE LAYER 1 : Cu

BASE INSULATING LAYER : PI — 121

METAL SUPPORTING SUBSTRATE — 126

## FIG.9G

122

| INSULATING LAYER 1 : PI | CONDUCTIVE LAYER 1 : Cu | — 123

BASE INSULATING LAYER : PI — 121

METAL SUPPORTING SUBSTRATE — 126

## FIG.9H

CONDUCTIVE OPENING PORTION   CONDUCTIVE OPENING PORTION

122

INSULATING LAYER 1 : PI   CONDUCTIVE LAYER 1 : Cu

BASE INSULATING LAYER : PI — 121

METAL SUPPORTING SUBSTRATE — 126

FIG.9I

CONDUCTIVE LAYER 2 : Cu
123a    123a
122
CONDUCTIVE LAYER 2 : Cu — 124
INSULATING LAYER 1 : PI
CONDUCTIVE LAYER 1 : Cu
123
BASE INSULATING LAYER : PI — 121
METAL SUPPORTING SUBSTRATE — 126

FIG.9J

INSULATING LAYER 2 : PI    123a    123a
CONDUCTIVE LAYER 2 : Cu    122    — 125
CONDUCTIVE LAYER 2 : Cu — 124
INSULATING LAYER 1 : PI
CONDUCTIVE LAYER 1 : Cu
123
BASE INSULATING LAYER : PI — 121
METAL SUPPORTING SUBSTRATE — 126

FIG.9K

INSULATING LAYER 2 : PI    123a    123a
CONDUCTIVE LAYER 2 : Cu    122    — 125
CONDUCTIVE LAYER 2 : Cu — 124
INSULATING LAYER 1 : PI
CONDUCTIVE LAYER 1 : Cu
123
BASE INSULATING LAYER : PI — 121
METAL SUPPORTING SUBSTRATE    METAL SUPPORTING SUBSTRATE — 126

FIG.10

FIG.11A

123a   131(1311)   123a

123b   123b

12   13   12

126
121
122
123
124
125
127
128

FIG.11B

122

X   X

123b   123a   1311   1312   123a   123b

EP 4 057 305 A1

Europäisches
Patentamt

European
Patent Office

Office européen
des brevets

# EUROPEAN SEARCH REPORT

Application Number

EP 22 15 8208

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/075648 A1 (NASU TAKAFUMI [JP] ET AL) 7 March 2019 (2019-03-07) * 2, 40-45 and 47-49; figures 1, 2, 3A-3C, 4 * ----- | 1-3,5-7 | INV. H01F27/28 H01F27/40 H01F38/14 H05K1/02 |
| X | WO 2020/158025 A1 (NITTO DENKO CORP [JP]) 6 August 2020 (2020-08-06) * 42, 46, 60, 61, 73-75, 102, 103, 111, 115 and 116; figures 3-5 * ----- | 1-3,5-7 | |
| X | US 2020/053887 A1 (BUND ROLAND [AT]) 13 February 2020 (2020-02-13) * 39, 43 and 72; claim 12; figures 5, 6 * ----- | 1-7 | |
| A | US 2018/279468 A1 (CHEN YAN [CN]) 27 September 2018 (2018-09-27) * 17-23; figures 1, 2 * ----- | 6,7 | |
| A | CN 105 682 343 B (GUANGDONG OPPO MOBILE TELECOMMUNICATIONS CORP LTD) 2 April 2019 (2019-04-02) * 18-20; figure 1 * ----- | 6,7 | TECHNICAL FIELDS SEARCHED (IPC) H01F H02J H05K |

The present search report has been drawn up for all claims

| Place of search | Date of completion of the search | Examiner |
|---|---|---|
| Munich | 28 July 2022 | Brächer, Thomas |

EPO FORM 1503 03.82 (P04C01)

**EP 4 057 305 A1**

## ANNEX TO THE EUROPEAN SEARCH REPORT
## ON EUROPEAN PATENT APPLICATION NO.

EP 22 15 8208

This annex lists the patent family members relating to the patent documents cited in the above-mentioned European search report.
The members are as contained in the European Patent Office EDP file on
The European Patent Office is in no way liable for these particulars which are merely given for the purpose of information.

28-07-2022

| Patent document cited in search report | | Publication date | Patent family member(s) | | Publication date |
|---|---|---|---|---|---|
| US 2019075648 | A1 | 07-03-2019 | CN | 109075822 A | 21-12-2018 |
| | | | JP | 6696573 B2 | 20-05-2020 |
| | | | JP WO2018021060 A1 | | 22-03-2019 |
| | | | US | 2019075648 A1 | 07-03-2019 |
| | | | WO | 2018021060 A1 | 01-02-2018 |
| WO 2020158025 | A1 | 06-08-2020 | JP | 2020123524 A | 13-08-2020 |
| | | | WO | 2020158025 A1 | 06-08-2020 |
| US 2020053887 | A1 | 13-02-2020 | US | 2020053887 A1 | 13-02-2020 |
| | | | US | 2020367370 A1 | 19-11-2020 |
| US 2018279468 | A1 | 27-09-2018 | CN | 105578720 A | 11-05-2016 |
| | | | CN | 108551720 A | 18-09-2018 |
| | | | EP | 3361835 A1 | 15-08-2018 |
| | | | US | 2018279468 A1 | 27-09-2018 |
| | | | WO | 2017113813 A1 | 06-07-2017 |
| CN 105682343 | B | 02-04-2019 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018174123 A